# EUROPEAN PATENT APPLICATION

(11) **EP 0 629 046 A1**
(43) Date of publication of application: **14.12.1994**
(21) Application number: 93304539.5
(22) Date of filing: 11.06.1993
(51) Int. Cl.: H03K 17/06

(54) **Low-resistance high-speed electronic switch**

(71) Applicant: INDUSTRIAL TECHNOLOGY RESEARCH INSTITUTE, Chutung, Hsinchu 31015 (TW)
(72) Inventor: Chen, Chun-Chun, Chutung 31015, Hsinchu (TW); Tsao, S. Hoi, Chutung 31015, Hsinchu (TW)
(74) Representative: Skone James, Robert Edmund

(57) **Abstract**

An electronic switch comprises a switch device (2) and an on-resistance (Ron) compensation feed-back controller (1). The Ron compensation feed-back controller (1) is able to bypass the current flow of the switch (2) to the Ron compensation feed-back controller (1) when the switch device is on. A further feature is the provision of an off resistance (Roff) enhancement circuit (3) to provide a higher off resistance.

## Description

The present invention relates to a low-resistant high-speed electronic switch, especially to an electronic switch with very short reaction time and low Ron (The effective series resistance of a switch when it is in the ON state). According to this invention the reaction time of the low-resistance high-speed electronic switch may be several microseconds with its Ron of less than one milliohm. The switch of the present invention is suitable for electronic components used in precise instruments.

It has been a development in electrical switching techniques to use electronic signals, in replacement of mechanical operation such as used in conventional relays, in the control of switch devices. Electronic switches, such as MOSFET switches, are welcomed by their users because of its compactness and short reaction time of several microseconds. Mechanical switches are, however, still commonly used by the industry, because they have lower Ron than electronic switches. In application the Ron of mechanical switches ranges about several milliohms but Ron of electronic switches ranges about several ohms. As a result, mechanical switches are always used in precise electronic circuits such as in the automatic control systems of precise measurement instruments, in spite of their longer reaction time (in milliseconds).

It is thus a need of the industry to have an electronic switch which has lower on-resistance and shorter reaction time.

In accordance with the present invention, an electronic switch comprises a switching device and a Ron compensation feed-back control circuit, wherein the Ron compensation feed-back control device bypasses the current flow of the switching device to the Ron compensation feed-back control device while the switching device is on. The most significant advantage of this invention is its low Ron and high reaction speed. With the help of the Ron compensation feed-back control circuit, the Ron of this invention may be reduced to several milliohms or less, with reaction time of about several microseconds.

The invention provides a low-resistance high speed electronic switch with lower Ron and shorter reaction time.

The invention also provides a low-resistance high-speed electronic switch with lower Ron and higher off-resistance (Roff).

The invention also provides a low-resistance high-speed electronic switch which may be used in highly isolated environments.

Preferably, the invention further comprises a Roff enhancement circuit and a highly isolated power supply. This invention also results in a higher Roff and is suitable for applications in highly isolated environments.

The above and other features and advantages of the invention will be more apparent from the following description of a preferred embodiment thereof as illustrated in the accompanying drawings, in which:-
Figure 1 is a system diagram of the low-resistance high-speed electronic switch of the invention; and,
Figure 2 is a circuit diagram of a preferred embodiment of the low-resistance high-speed electronic switch of the invention.

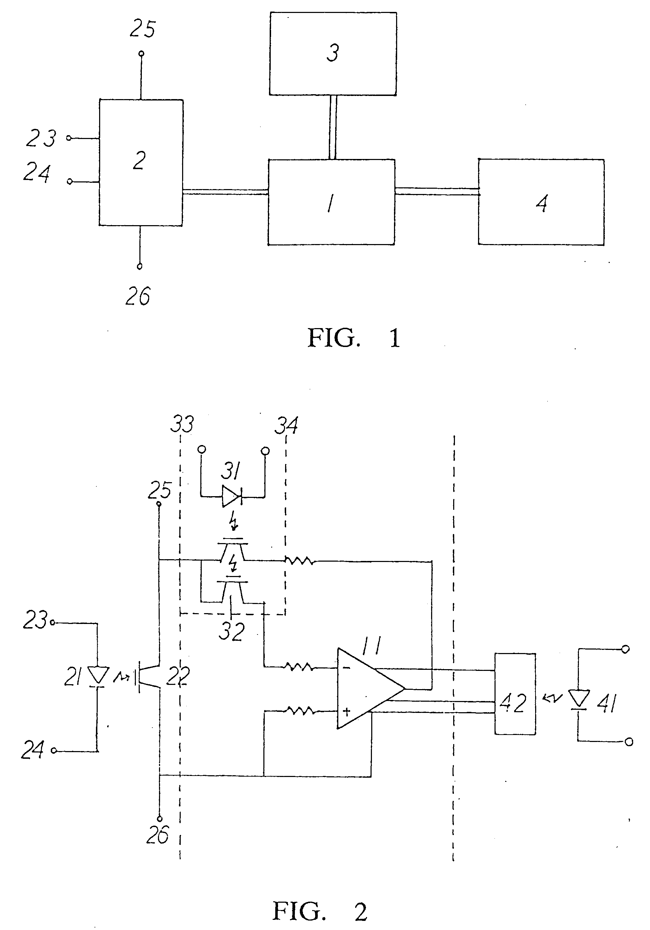

Figure 1 is a system diagram of the low-resistance high-speed electronic switch of the invention. According to Figure 1, the low-resistance high-speed electronic switch of the invention comprises a Ron compensation feed-back circuit 1 and a switching device 2. The Ron compensation feed-back control circuit 1 may bypass the current flow of the switching device 2 to the Ron compensation feed-back control circuit 1 while the switching device 2 is on, so that the voltage drop across the switching device 2 may be reduced, thus lowering the effective Ron of the switching device 2. 3 represents a Roff enhancement circuit which maintains a high off-resistance while the switching device 2 is off. The Roff enhancement circuit 3 enhances the Roff by avoiding an expected decrease in the Roff of the circuit because of the additional Ron compensation circuit 1. 4 is a highly isolated power supply, used to supply electric power to the Ron compensation feed-back control circuit 1. 23 and 24 are control inputs for the switching device 2 and 26 and 25 are signal input and output respectively.

Fig. 2 is a circuit diagram of an embodiment of the low-resistance high-speed electronic switch of this invention. As shown in the figure, the low-resistance high-speed electronic switch includes at least a light emitting diode (LED) 21, a opto-electronic switch 22 and an operational amplifier 11. In this circuit, when the light emitted by the LED 21 reaches the opto-electronic switch 22, the switch 22 turns on. Normally the resistance value of the opto-electronic switch is about several ohms. However, switch's current flow is bypassed to the operational amplifier 11 so that, in effect, the Ron of this circuit can be lowered to about several milliohm.

When the circuit turns off, the operational amplifier 11 in the circuit may reduce the off-resistance of the circuit. In this embodiment an opto-electronic switch 32 is introduced adjacent to the operational amplifier 11 and LED 31, which operation is synchronized with that of the LED 21, is used to control the opto-electronic switch 32. In actual application LED 21 and LED 31 may be one LED. As the opto-electronic switch 32 turns off at the same time when the opto-electronic switches 22 turns off, the Roff of the switch 22 will be very high, because the operational amplifier 11 will not affect the Roff of the switch 22.

In order to use the invention under highly isolated environments, this embodiment includes an opto-electric cell 42 as the power supply of the operational amplifier 11. In actual application the light source of the opto-electric cell 41 may be the same light source of the switches 22 and 32, in other words, the LED 21 or 31. As a result in the embodiment, only one LED may be used to function as an isolated power source for the operational amplifier 11 and the source of control signals for the opto-electronic switches 22 and 32.

Results of experiments proved that the low-resistance high-speed electronic switch of this invention has the following effects:
1. Reaction time: approximately several microseconds.
2. Ron: approximately several milliohm.
3. Roff: approximately several T ohm (10¹² ohm).

Using only one LED to function as power source as well as emitter of control signals is also a novel advantage of this invention.

## Claims

1. An electronic switch comprising:
a switching device (2); and
an on-resistance (Ron) compensation feed-back control device (1); wherein the Ron compensation feed-back control device bypasses the current flow of the switching device (2) to the Ron compensation feed-back control device (1) while the switching device is on.

2. A switch according to claim 1, wherein the switching device (2) comprises a light source (21) and a opto-electronic switch (22) and the Ron compensation feed-back control device (1) comprises an operational amplifier (11).

3. A switch according to claim 1 or claim 2, further comprising an off resistance (Roff) enhancement circuit (3), to isolate the resistance value of the Ron compensation feed-back control device (1) while the switching device (2) is off.

4. A switch according to claim 3, when dependent on claim 2, wherein the Roff enhancement circuit (3) comprises a light source (31) and an opto-electronic switch (32).

5. A switch according to claim 4, wherein a common light source is provided for the switching device (2) and for the Roff enhancement circuit (3).

6. A switch according to any preceding claim, further comprising an isolated power supply (4) to supply electric power to the Ron compensation feed-back control device (2).

7. A switch according to claim 6 when dependent on at least claim 4, wherein the isolated power supply (4) is an opto-electric cell.

8. A switch according to claim 7, wherein a common light source is provided for the switching device (2) the Roff enhancement circuit (3) and the opto-electric cell (42).
